# EUROPEAN PATENT APPLICATION

(11) **EP 3 664 156 A1**
(43) Date of publication of application: **10.06.2020**
(21) Application number: 18885104.2
(22) Date of filing: 18.09.2018
(51) Int. Cl.: H01L 31/0224, H01L 31/068, H01L 31/0747

(54) **SOLAR CELL AND ELECTRONIC DEVICE PROVIDED WITH SAID SOLAR CELL**

(30) Priority: 04.12.2017 JP 2017232916
(71) Applicant: Kaneka Corporation, Osaka-shi, Osaka 530-8288 (JP)
(72) Inventor: UZU Hisashi, Settsu-shi Osaka 566-0072 (JP); KUCHIYAMA Takashi, Settsu-shi Osaka 566-0072 (JP); YOSHIKAWA Kunta, Settsu-shi Osaka 566-0072 (JP)
(74) Representative: V.O.
(86) International application number: PCT/JP2018/034360
(87) International publication number: WO 2019/111491

(57) **Abstract**

Provided is a solar cell from which an output is easily derived even if the solar cell is cut into an arbitrary shape. A solar cell 1 according to the present invention is a back contact solar cell which is provided with: a semiconductor substrate 11; a first conductivity-type semiconductor layer 25 and a second conductivity-type semiconductor layer 35, which are arranged on the back surface of the semiconductor substrate 11; and first electrode layers 27 which correspond to the first conductivity-type semiconductor layer 25, and a second electrode layer 37 which corresponds to the second conductivity-type semiconductor layer 35. The second electrode layer 37 and the plurality of first electrode layers 27 form a sea-island structure wherein the first electrode layers 27 are in the form of islands, while the second electrode layer 37 is in the form of sea. This solar cell 1 is also provided with a plate electrode 40 which is arranged so as to face the back surface of the semiconductor substrate 11, and which is connected to the plurality of first electrode layers 27, while being not connected to the second electrode layer 37.

## Description

### TECHNICAL FIELD

The present invention relates to a back electrode type (back contact type) (also called back junction type) solar cell and an electronic device including the solar cell.

### BACKGROUND ART

Examples of a solar cell using a semiconductor substrate include a double-sided electrode type solar cell having electrodes formed on the both surfaces of a light reception surface and a back surface, and a back electrode type solar cell having electrodes formed only on the back surface. Since such a double-sided electrode type solar cell has electrodes formed on the light reception surface, the electrodes shield sunlight. On the other hand, such a back electrode type solar cell has no electrode formed on the light reception surface, and thus such a back electrode type solar cell has higher receiving efficiency of sunlight as compared with such a double-sided electrode type solar cell. Patent Documents 1 and 2 disclose back electrode type solar cells.

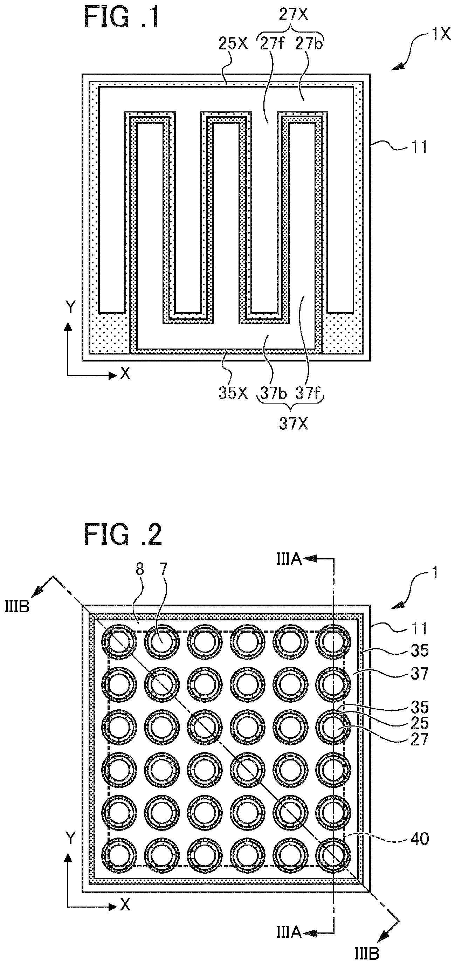

FIG. 1 shows such a conventional back electrode type solar cell as viewed from a back surface side. A solar cell 1X shown in FIG. 1 includes a first conductivity type semiconductor layer 25X and a second conductivity type semiconductor layer 35X formed on a back surface of a semiconductor substrate 11. The first conductivity type semiconductor layer 25X is formed into a so-called comb shape with a plurality of finger parts corresponding to comb teeth and a bus bar part corresponding to a supporting part of the comb teeth. The bus bar part extends in an X direction along one peripheral portion of the semiconductor substrate 11. The finger parts extend from the bus bar part in a Y direction intersecting the X direction. Similarly, the second conductivity type semiconductor layer 35X is formed into a so-called comb shape with a plurality of finger parts corresponding to comb teeth and a bus bar part corresponding to a supporting part of the comb teeth. The bus bar part extends in the X direction along the other peripheral portion facing the one peripheral portion of the semiconductor substrate 11. The finger parts extend from the bus bar part in the Y direction. The finger parts of the first conductivity type semiconductor layer 25X and the finger parts of the second conductivity type semiconductor layer 35X are arranged alternately in the X direction. In this way, a forming region of the first conductivity type semiconductor layer 25X and a forming region of the second conductivity type semiconductor layer 35X have shapes like comb teeth in meshing engagement with each other. This structure allows photocarriers induced in the semiconductor substrate 11 in response to incident light from a light reception surface to be collected efficiently at each of the semiconductor layers.

A first electrode layer 27X and a second electrode layer 37X for extracting the collected photocarriers to the outside are provided on the first conductivity type semiconductor layer 25X and the second conductivity type semiconductor layer 35X respectively. The first electrode layer 27X is formed into a so-called comb shape with a plurality of finger parts 27f corresponding to comb teeth and a bus bar part 27b corresponding to a supporting part of the comb teeth. The bus bar part 27b extends in the X direction along one peripheral portion of the semiconductor substrate 11. The finger parts 27f extend from the bus bar part 27b in the Y direction intersecting the X direction. Similarly, the second electrode layer 37X is formed into a so-called comb shape with a plurality of finger parts 37f corresponding to comb teeth and a bus bar part 37b corresponding to a supporting part of the comb teeth. The bus bar part 37b extends in the X direction along the other peripheral portion facing the one peripheral portion of the semiconductor substrate 11. The finger parts 37f extend from the bus bar part 37b in the Y direction. The finger parts 27f and the finger parts 37f are arranged alternately in the X direction (see Patent Document 1, for example).

A wiring member is connected to each of the bus bar parts 27b and 37b. A plurality of solar cells 1X is connected in series or in parallel via these wiring members to be configured as a module. There has also been a technique of configuring a plurality of solar cells 1X as a module by connecting the finger parts 27f and the finger parts 37f using a wiring sheet instead of the bus bar parts 27b and 37b and the wiring members and by connecting the solar cells 1X in series or in parallel (see Patent Document 2, for example).
Patent Document 1: Japanese Unexamined Patent Application, Publication No. 2009-200267
Patent Document 2: Japanese Unexamined Patent Application, Publication No. 2010-092981

### DISCLOSURE OF THE INVENTION

### Problems to be Solved by the Invention

Products of high design quality are required as electronic devices such as wearable devices or wristwatches, and products having a variety of shapes are expected to be designed. Hence, a variety of shapes conforming to the shapes of electronic devices are also considered to be required for products of solar cells to be installed on such electronic devices. However, producing solar cells of various shapes for respective electronic devices, which is manufacture of a wide variety of products in small quantities, is not a realistic way of production.

In this regard, cutting a solar cell into an arbitrary shape on a customer side may be feasible. Regarding the conventional back electrode type solar cell 1X shown in FIG. 1, however, cutting the solar cell 1X into an arbitrary shape may separate the finger parts 27f of the first electrode layer 27X and this may cause absence of a wiring member connected to the bus bar part 27b. This makes it difficult to extract carriers collected at the first electrode layer 27X, namely, extract output of the solar cell 1X.

The present invention is intended to provide a solar cell that facilitates extraction of output even if the solar cell is cut into an arbitrary shape, and an electronic device including the solar cell.

### Means for Solving the Problems

A solar cell according to the present invention is a back electrode type solar cell including a semiconductor substrate, a first conductivity type semiconductor layer and a second conductivity type semiconductor layer arranged on a back surface of the semiconductor substrate, a first electrode layer corresponding to the first conductivity type semiconductor layer, and a second electrode layer corresponding to the second conductivity type semiconductor layer. The second electrode layer and a plurality of the first electrode layers form a sea-island structure in which the first electrode layers have island shapes and the second electrode layer has a sea shape. The solar cell includes a plate-like electrode arranged to face the back surface of the semiconductor substrate, connected to a plurality of the first electrode layers, and not connected to the second electrode layer.

Another solar cell according to the present invention is a back electrode type solar cell including a semiconductor substrate, a first conductivity type semiconductor layer and a second conductivity type semiconductor layer arranged on a back surface of the semiconductor substrate, a first electrode layer corresponding to the first conductivity type semiconductor layer, and a second electrode layer corresponding to the second conductivity type semiconductor layer. The second electrode layer and a plurality of the first electrode layers form a sea-island structure in which the first electrode layers have island shapes and the second electrode layer has a sea shape. The solar cell includes an insulating layer covering the second electrode layer while a plurality of the first electrode layers is exposed from the insulating layer.

An electronic device according to the present invention includes the solar cell described above.

### Effects of the Invention

According to the present invention, a solar cell that facilitates extraction of output even if the solar cell is cut into an arbitrary shape, and an electronic device including the solar cell can be provided.

### BRIEF DESCRIPTION OF THE DRAWINGS

FIG. 1 shows a conventional solar cell as viewed from a back surface side;
FIG. 2 shows a solar cell according to the present embodiment as viewed from a back surface side;
FIG. 3A is a cross-sectional view taken along a line IIIA-IIIA in the solar cell shown in FIG. 2;
FIG. 3B is a cross-sectional view taken along a line IIIB-IIIB in the solar cell shown in FIG. 2;
FIG. 4A shows how the conventional solar cell is cut into a circular shape;
FIG. 4B shows how the conventional solar cell is cut into the circular shape;
FIG. 5A shows how the solar cell according to the present embodiment is cut into a circular shape;
FIG. 5B shows how the solar cell according to the present embodiment is cut into the circular shape;
FIG. 6A shows the solar cell (with extraction electrodes) according to the present embodiment as viewed from the back surface side;
FIG. 6B is a cross-sectional view taken along a line VIB-VIB in the solar cell shown in FIG. 6A;
FIG. 7A shows a solar cell (with extraction electrodes) according a modification of the present embodiment as viewed from a back surface side;
FIG. 7B is a cross-sectional view taken along a line VIIB-VIIB in the solar cell shown in FIG. 7A;
FIG. 8A shows an exemplary procedure of producing the solar cell according to the present embodiment;
FIG. 8B shows the exemplary procedure of producing the solar cell according to the present embodiment;
FIG. 8C shows the exemplary procedure of producing the solar cell according to the present embodiment;
FIG. 9 shows a solar cell according to a first modification of the present embodiment as viewed from a back surface side;
FIG. 10 shows a solar cell according to a second modification of the present embodiment as viewed from a back surface side;
FIG. 11 is a cross-sectional view of a solar cell according to a third modification of the present embodiment;
FIG. 12 is a cross-sectional view of a solar cell according to a fourth modification of the present embodiment;
FIG. 13 shows a solar cell after cutting according to a fifth modification of the present embodiment as viewed from a back surface side; and
FIG. 14 shows a solar cell according to a sixth modification of the present embodiment as viewed from a back surface side.

### PREFERRED MODE FOR CARRYING OUT THE INVENTION

Examples of an embodiment according to the present invention will be described below by referring to the accompanying drawings. It is noted that, in the drawings, the same or corresponding parts are denoted by the same reference numerals. For the sake of convenience, hatching, member reference numerals, etc. may be omitted. However, in such cases, other drawings shall be referred to.

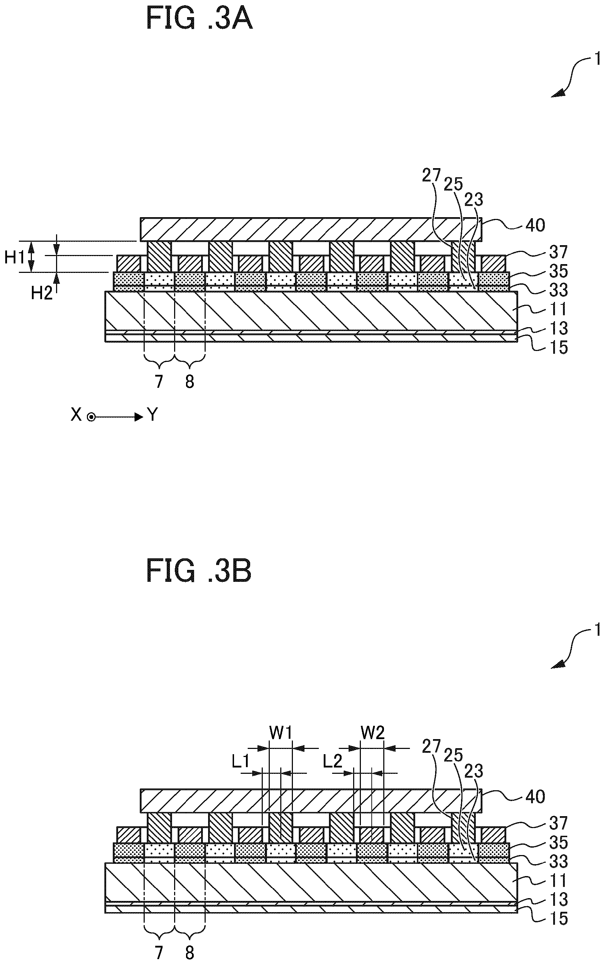

FIG. 2 shows a solar cell according to the present embodiment as viewed from a back surface side. FIG. 3A is a cross-sectional view taken along a line IIIA-IIIA in the solar cell shown in FIG. 2. FIG. 3B is a cross-sectional view taken along a line IIIB-IIIB in the solar cell shown in FIG. 2. As shown in FIGS. 2, 3A, and 3B, a solar cell 1 is a back electrode type (back junction type) solar cell. The solar cell 1 includes a semiconductor substrate 11 having two major surfaces, and includes a plurality of first conductivity type regions 7 and one second conductivity type region 8 at the major surfaces of the semiconductor substrate 11.

The first conductivity type regions 7 and the second conductivity type region 8 form a sea-island structure. In the sea-island structure, a sea region is a physically continuous one region and electrically, a region having one electrical characteristic (positive or negative). On the other hand, the island regions are floating (isolated) regions in the sea region and has an electrical characteristic opposing the electrical characteristic of the sea region. The first conductivity type regions 7 correspond to the island regions and the second conductivity type region 8 corresponds to the sea region (in the following, the first conductivity type regions 7 will also be called the island regions and the second conductivity type region 8 will also be called the sea region). The island regions 7 each have a circular shape in a plan view of the major surface of the semiconductor substrate 11, for example. The shape of the island region 7 is not limited to the circular shape but it may also be a strip-like shape or a polygonal shape (rectangular shape, for example) (see a second modification described later, for example). The island regions 7 are arranged two-dimensionally at the major surface of the semiconductor substrate 11. More specifically, the island regions 7 are arranged at substantially equal intervals on points of intersection in an orthogonal grid (grid points). The sea region 8 occupies an entire region of the major surface of the semiconductor substrate 11 except the island regions 7 and a perimeter area of the semiconductor substrate 11. The sea region 8 may be arranged further at the perimeter area of the semiconductor substrate 11. This achieves increase in effective power generation area to allow increase in photoelectric conversion efficiency.

The solar cell 1 includes a passivation layer 13 and an anti-reflective layer 15 sequentially laminated on one major surface on a light reception side of the major surfaces of the semiconductor substrate 11. The solar cell 1 further includes a passivation layer 23, a first conductivity type semiconductor layer 25, and a first electrode layer 27 sequentially laminated in the island region 7 at a back surface corresponding to the other of the major surfaces of the semiconductor substrate 11 on the opposite side of the light reception surface. The solar cell 1 further includes a passivation layer 33, a second conductivity type semiconductor layer 35, and a second electrode layer 37 sequentially laminated in the sea region 8 at the back surface of the semiconductor substrate 11. The solar cell 1 further includes a plate-like electrode 40 laminated on the first electrode layer 27 in the island region 7 at the back surface of the semiconductor substrate 11. In FIG. 2, the plate-like electrode 40 is indicated by dashed lines and the laminated structure of the solar cell 1 at the plate-like electrode 40 is shown in a perspective view.

### <Semiconductor substrate>

A conductive single crystal silicon substrate, for example, an n-type single crystal silicon substrate or a p-type single crystal silicon substrate is used as the semiconductor substrate 11. This achieves high photoelectric conversion efficiency. The semiconductor substrate 11 is preferably an n-type single crystal silicon substrate. In an n-type single crystalline silicon substrate, a carrier lifetime is longer. This is because, in a p-type single crystal silicon substrate, light induced degradation (LID) may occur, in which light irradiation affects boron (B), which is a p-type dopant, and thereby a carrier becomes a recombination center. On the other hand, in an n-type single crystal silicon substrate, LID is further suppressed from occurring.

The semiconductor substrate 11 may have a fine uneven structure of a pyramidal shape called a texture structure provided on the back surface. This increases efficiency of collecting light having passed through the semiconductor substrate 11 without being absorbed in the semiconductor substrate 11. The semiconductor substrate 11 may have a fine uneven structure of a pyramidal shape called a texture structure provided on the light reception surface. This reduces reflection of incident light on the light reception surface to improve optical confinement effect in the semiconductor substrate 11.

The thickness of the semiconductor substrate 11 is preferably between 50 and 200 pm inclusive, more preferably between 60 and 180 pm inclusive, and still more preferably between 70 and 180 pm inclusive. Forming the semiconductor substrate 11 into such a small thickness achieves increase in open-circuit voltage and reduction in costs of material of the solar cell 1. It is noted that, as the semiconductor substrate 11, a conductive polycrystalline silicon substrate may be used, for example, an n-type polycrystalline silicon substrate or a p-type polycrystalline silicon substrate. In this case, a solar cell is manufactured at lower costs.

### <Anti-reflective layer>

The anti-reflective layer 15 is formed on the light reception surface of the semiconductor substrate 11 via the passivation layer 13. The passivation layer 13 is formed as an intrinsic silicon-based layer. The passivation layer 13 functions to terminate surface defect of the semiconductor substrate 11 to suppress carrier recombination. A translucent film having a refractive index of approximately 1.5 to 2.3 inclusive is preferably used as the anti-reflective layer 15. As a material of the anti-reflective layer 15, SiO, SiN, or SiON is preferable, for example. While a method of forming the anti-reflective layer 15 is not particularly limited, a CVD method achieving precise control of a film thickness is preferably used. The film formation by the CVD method achieves control of film quality by controlling material gas or conditions for the film formation.

In the present embodiment, the light reception surface has no electrode formed (back electrode type), and such a solar cell has high receiving efficiency of sunlight, and thus the photoelectric conversion efficiency thereof is high.

### <First conductivity type semiconductor layer and second conductivity type semiconductor layer>

The first conductivity type semiconductor layer 25 is formed in the island region 7 at the back surface of the semiconductor substrate 11 via the passivation layer 23. The second conductivity type semiconductor layer 35 is formed in the sea region 8 at the back surface of the semiconductor substrate 11 via the passivation layer 33. In this way, the first conductivity type semiconductor layer 25 and the second conductivity type semiconductor layer 35 form a sea-island structure in which the first conductivity type semiconductor layer 25 corresponds to an island-shape semiconductor layer and the second conductivity type semiconductor layer 35 corresponds to a sea-shape semiconductor layer.

The first conductivity type semiconductor layer 25 is formed as a first conductivity type silicon-based layer, for example, a p-type silicon-based layer. The second conductivity type semiconductor layer 35 is formed as a silicon-based layer of a second conductivity type different from the first conductivity type, for example, an n-type silicon-based layer. The first conductivity type semiconductor layer 25 may be an n-type silicon-based layer, and the second conductivity type semiconductor layer 35 may be a p-type silicon-based layer. Each of the p-type silicon-based layer and the n-type silicon-based layer is formed of an amorphous silicon layer or a microcrystal silicon layer containing amorphous silicon and crystal silicon. Boron (B) is preferably used as dopant impurities in the p-type silicon-based layer. Phosphorus (P) is preferably used as dopant impurities in the n-type silicon-based layer.

While a method of forming the first conductivity type semiconductor layer 25 and the second conductivity type semiconductor layer 35 is not particularly limited, a CVD method is preferably used. As an example, SiH₄ gas is preferably used as a material gas. As an example, hydrogen-diluted B₂H₆ or PH₃ is preferably used as a dopant addition gas. A very small quantity of impurities of, for example, oxygen or carbon may be added in order to improve light transmittance. In this case, gas, for example, CO₂ or CH₄ is introduced during film formation by the CVD method. As a different method of forming the first conductivity type semiconductor layer 25 and the second conductivity type semiconductor layer 35, a thermal diffusion doping method or a laser doping method is used.

In the back electrode type solar cell, light is received on the light reception surface and generated carriers are collected at the back surface. For this reason, the first conductivity type semiconductor layer 25 and the second conductivity type semiconductor layer 35 are formed in the same plane. A method of forming (patterning) the first conductivity type semiconductor layer 25 and the second conductivity type semiconductor layer 35 into predetermined shapes in the same plane is not particularly limited. A CVD method using a mask may be employed. Alternatively, an etching method using a resist, an etching solution, or etching paste may be employed, for example.

Preferably, the first conductivity type semiconductor layer 25 and the second conductivity type semiconductor layer 35 are not joined. Thus, an insulating layer (not shown) may be provided between these layers. If an insulating layer is provided at a boundary between a p-type silicon-based thin film and an n-type silicon-based thin film, and if the insulating layer is made of silicon oxide, for example, and is formed by a CVD method, a film forming step can be simplified to encourage reduction in process costs and improvement of yield.

### <Passivation layer>

The passivation layers 23 and 33 are each formed as an intrinsic silicon-based layer. The passivation layers 23 and 33 function to terminate surface defect of the semiconductor substrate 11 to suppress carrier recombination. This extends carrier lifetime to improve output of the solar cell.

### <First electrode layer and second electrode layer>

The first electrode layer 27 is formed on the first conductivity type semiconductor layer 25. The second electrode layer 37 is formed on the second conductivity type semiconductor layer 35. In this way, the first electrode layer 27 and the second electrode layer 37 form a sea-island structure in which the first electrode layer 27 corresponds to an island-shape electrode layer and the second electrode layer 37 corresponds to a sea-shape electrode layer. The first electrode layer 27 and the second electrode layer 37 are separated.

The first electrode layer 27 and the second electrode layer 37 are formed as transparent conductive layers made of a transparent conductive material. As the transparent conductive material, transparent conductive metal oxide is used, for example, indium oxide, tin oxide, zinc oxide, titanium oxide, and complex oxides thereof. An indium-based complex oxide mainly containing indium oxide is preferably used out of them. An oxide of indium is particularly preferably used, from the viewpoint of high conductivity and transparency. Furthermore, it is preferable to add dopant to an oxide of indium in order to ensure reliability or higher conductivity. Examples of the dopant include Sn, W, Zn, Ti, Ce, Zr, Mo, Al, Ga, Ge, As, Si and S. A method used for forming these transparent electrode layers is a physical vapor deposition method such as a sputtering method or a chemical vapor deposition method (CVD method, for example) using reaction of an organometallic compound with oxygen or water, for example.

The first electrode layer 27 and the second electrode layer 37 are not limited to the transparent electrode layers but they may include metal electrode layers laminated on the transparent electrode layers. Namely, the first electrode layer 27 and the second electrode layer 37 may be a laminated first electrode layer and a laminated second electrode layer each composed of the laminated transparent electrode layer and metal electrode layer. One of the first electrode layer and the second electrode layer may be a laminated electrode layer and the other may be a single-layer transparent electrode layer. Alternatively, both the first electrode layer 27 and the second electrode layer 37 may be single-layer transparent electrode layers or single-layer metal electrode layers. The metal electrode layers are made of a metal material. Examples of the metal material include Cu, Ag, Al, and an alloy of these materials. For example, a printing method such as screen printing using Ag paste or a plating method such as electrolytic plating using Cu is employed as a method of forming the metal electrode layers.

Preferably, the width of the first electrode layer 27 is smaller than that of the first conductivity type semiconductor layer 25, and the width of the second electrode layer 37 is smaller than that of the second conductivity type semiconductor layer 35. The width of the sea-shape second electrode layer 37 is the width of a portion in a predetermined direction caught between two island-shape first electrode layers 27 adjacent to each other in the predetermined direction (for example, the width of a portion in the X direction caught between two island-shape first electrode layers 27 adjacent to each other in the X direction, the width of a portion in the Y direction caught between two island-shape first electrode layers 27 adjacent to each other in the Y direction, or the width of a portion in a direction of 45 degrees tilted 45 degrees from the X direction and the Y direction caught between two island-shape first electrode layers 27 adjacent to each other in the direction of 45 degrees), or the width of a portion between the island-shape first electrode layer 27 and a perimeter of the semiconductor substrate 11. Likewise, the width of the sea-shape second conductivity type semiconductor layer 35 is the width of a portion in a predetermined direction caught between two island-shape first conductivity type semiconductor layers 25 adjacent to each other in the predetermined direction (for example, the width of a portion in the X direction caught between two island-shape first conductivity type semiconductor layers 25 adjacent to each other in the X direction, the width of a portion in the Y direction caught between two island-shape first conductivity type semiconductor layers 25 adjacent to each other in the Y direction, or the width of a portion in a direction of 45 degrees tilted 45 degrees from the X direction and the Y direction caught between two island-shape first conductivity type semiconductor layers 25 adjacent to each other in the direction of 45 degrees), or the width of a portion between the island-shape first conductivity type semiconductor layer 25 and a perimeter of the semiconductor substrate 11.

To efficiently extract photocarriers collected at the first conductivity type semiconductor layer 25 and the second conductivity type semiconductor layer 35, the first electrode layer 27 and the second electrode layer 37 preferably have largest possible widths. Thus, the width of the first electrode layer 27 is preferably greater than 0.5 times, more preferably, greater than 0.7 times the width of the first conductivity type semiconductor layer 25. Likewise, the width of the second electrode layer 37 is preferably greater than 0.5 times, more preferably, greater than 0.7 times the width of the second conductivity type semiconductor layer 35. If an insulating layer or another layer is provided at a boundary between the first conductivity type semiconductor layer 25 and the second conductivity type semiconductor layer 35 so the first electrode layer 27 and the second electrode layer 37 are separated from each other, the width of the first electrode layer 27 may be greater than that of the first conductivity type semiconductor layer 25, and the width of the second electrode layer 37 may be greater than that of the second conductivity type semiconductor layer 35.

On the other hand, to efficiently collect photocarriers in the semiconductor substrate 11 using the first conductivity type semiconductor layer 25 and the second conductivity type semiconductor layer 35, the respective widths of the first electrode layer 27 and the second electrode layer 37 preferably have some certain degrees of smallness. A distance by which minority carriers can move within the semiconductor substrate 11 without being recombined with majority carriers is determined in a manner that depends on the resistivity of the substrate, etc. This distance is equal to or less than about 3 mm in a silicon substrate generally used in a solar cell. If the conductivity type of the semiconductor substrate 11 is an n-type, the island-shape first conductivity type semiconductor layer 25 is a p-type semiconductor layer, and the sea-shape second conductivity type semiconductor layer 35 is an n-type semiconductor layer, the island-shape first conductivity type semiconductor layer 25 and first electrode layer 27 function to collect holes, and the sea-shape second conductivity type semiconductor layer 35 and second electrode layer 37 function to collect electrons. Referring to FIG. 3B, on the assumption that holes are generated in the semiconductor substrate 11 under the sea-shape second conductivity type semiconductor layer 35, a distance L2 from an edge of the island-shape first electrode layer 27 to the center of the sea-shape second electrode layer 37 is preferably equal to or less than 3 mm corresponding to a movable distance of holes, more preferably, equal to or less than 1 mm, particularly preferably, equal to or less than 0.5 mm. In other words, the sea-shape second electrode layer 37 has a width W2 that is preferably equal to or less than 6 mm, more preferably, equal to or less than 2 mm, particularly preferably, equal to or less than 1 mm. In this case, while a width W1 of the island-shape first electrode layer 27 may take any value, it is preferably substantially equal to the width W2 of the sea-shape second electrode layer 37 in consideration of resistance loss at the semiconductor substrate 11. The width W2 of the sea-shape second electrode layer 37 and the distance L2 about the sea-shape second electrode layer 37 corresponds to a distance on a line IIIB-IIIB along which the islands are separated at the greatest distance (along which carriers move a greatest distance) in FIG. 2. Further, the center of the sea-shape second electrode layer 37 corresponds to a center on the line IIIB-IIIB.

If the conductivity type of the semiconductor substrate 11 is an n-type, the island-shape first conductivity type semiconductor layer 25 is an n-type semiconductor layer, and the sea-shape second conductivity type semiconductor layer 35 is a p-type semiconductor layer, the island-shape first conductivity type semiconductor layer 25 and first electrode layer 27 function to collect electrons, and the sea-shape second conductivity type semiconductor layer 35 and second electrode layer 37 function to collect holes. Referring to FIG. 3B, on the assumption that holes are generated in the semiconductor substrate 11 under the island-shape first conductivity type semiconductor layer 25, a distance L1 from an edge of the sea-shape second electrode layer 37 to the center of the island-shape first electrode layer 27 is preferably equal to or less than 3 mm corresponding to a movable distance of holes, more preferably, equal to or less than 1 mm, particularly preferably, equal to or less than 0.5 mm. In other words, the island-shape first electrode layer 27 has a width W1 that is preferably equal to or less than 6 mm, more preferably, equal to or less than 2 mm, particularly preferably, equal to or less than 1 mm. In this case, while the width W2 of the sea-shape second electrode layer 37 may take any value, it is preferably substantially equal to the width W1 of the island-shape first electrode layer 27 in consideration of resistance loss at the semiconductor substrate 11.

In such a case where the island-shape first conductivity type semiconductor layer 25 is an n-type semiconductor layer, even if connection failure occurs between the plate-like electrode 40 and the island-shape first electrode layer 27 to disable collection of electrons at this isolated island-shape first electrode layer 27, electrons capable of moving a long distance can reach a different adjacent island-shape first electrode layer 27. This produces an advantage in terms of suppressing loss due to the connection failure. Providing the same conductivity type of the semiconductor substrate 11 and the island-shape first conductivity type semiconductor layer 25 in this way allows collection of majority carriers at the island-shape first electrode layer 27. Thus, even on the occurrence of the connection failure between the plate-like electrode 40 and the island-shape first electrode layer 27, majority carriers are still collected at a different island-shape first electrode layer 27 to suppress loss due to the connection failure. The foregoing description proceeds on the assumption that the conductivity type of the semiconductor substrate 11 is an n-type, for example. If the conductivity type of the semiconductor substrate 11 is a p-type, the width of an electrode layer to function to collect holes as majority carriers is also preferably equal to or less than 6 mm, more preferably, equal to or less than 2 mm, particularly preferably, equal to or less than 1 mm.

As shown in FIG. 3A, a height H1 of the first electrode layer 27 is greater than a height H2 of the second electrode layer 37. This facilitates connection between the plate-like electrode 40 and the first electrode layer 27 while preventing the plate-like electrode 40 and the second electrode layer 37 from contacting each other. A difference between the height H1 of the first electrode layer 27 and the height H2 of the second electrode layer 37 is preferably equal to or more than 1 pm, more preferably, between 1 and 150 pm inclusive, still more preferably, between 5 and 80 pm inclusive. A method of forming the first electrode layer 27 into a greater height than the second electrode layer 37 is not particularly limited. As an example, after formation of the second electrode layer 37, printing or plating may be performed in a region where the first electrode layer 27 is to be formed. The portion of the greater height of the first electrode layer 27 may be made of a material same as or different from a material used for forming the other region of the electrode layer.

Increasing the height of the second electrode layer 37 increases a cross-sectional area for a current to flow in a plane direction, thereby achieving reduction in series resistance. However, increasing the height of an electrode layer increases stress at an interface between a semiconductor layer and the electrode layer, and this may cause detachment of an electrode. Moreover, in a back electrode type solar cell in which an electrode is provided only on one surface, increasing the height of an electrode layer causes a stress unbalance between the front and back of a substrate. In this case, deformation such as deflection of the solar cell is likely to occur, and this may cause breakage of the solar cell. If the solar cell is deformed by stress at an electrode interface, trouble such as misalignment or short-circuit may occur during configuration of the solar cell as a module. For this reason, the height H2 of the second electrode layer 37 is preferably equal to or less than 100 pm, more preferably, equal to or less than 60 pm, still more preferably, equal to or less than 30 pm. The height of an electrode is a distance from a major surface of a substrate to the top of the electrode. In the presence of a region of the substrate where a thickness is reduced partially by etching for forming a semiconductor layer, for example, a reference plane parallel to a major surface of the substrate may be defined, and a distance from the reference plane to the top of the electrode may be defined as the height of the electrode.

### <Plate-like electrode>

The plate-like electrode 40 is provided to face the semiconductor substrate 11 and connected to a plurality of the island-shape first electrode layers 27. The plate-like electrode 40 is made of a metal material. Examples of the metal material include Cu, Ag, Al, and an alloy of these materials. For example, a printing method such as screen printing using Ag paste or a plating method such as electrolytic plating using Cu is employed as a method of forming the plate-like electrode 40. Alternatively, the plate-like electrode 40 may be formed by laminating metal sheets such as copper foil or wiring sheets prepared in advance. In this case, the plate-like electrode 40 and a plurality of the island-shape first electrode layers 27 may be connected with an adhesive, for example. If screen printing using Ag paste is employed for forming the plate-like electrode 40, for example, the plate-like electrode 40 is formed into an electrode containing Ag particles. The plate-like electrode 40 may be a lattice-like or mesh-like flat plate.

### (Cutting)

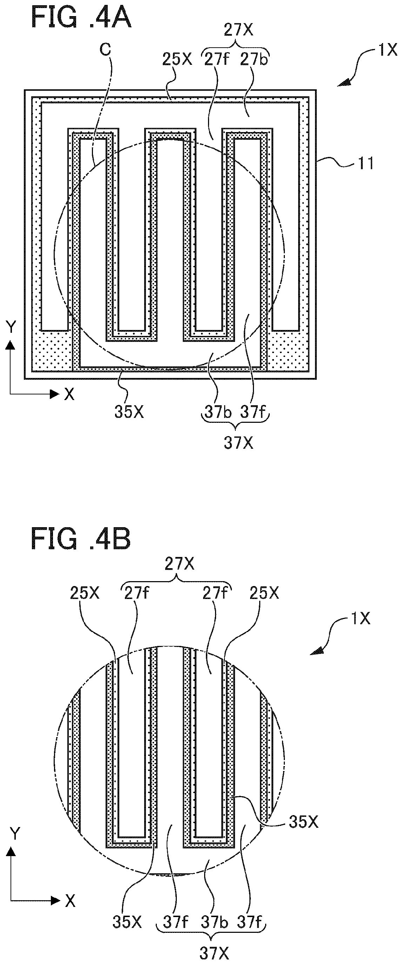

The following describes cutting of the solar cell 1 described above into an arbitrary shape. The solar cell 1 may be cut by a customer or by a manufacturer before shipment. FIGS. 4A and 4B show how the conventional solar cell 1X shown in FIG. 1 is cut into a circular shape. A solar cell having a circular shape shown in FIG. 4B is obtained by cutting the solar cell 1X along a circular cutting line C shown in FIG. 4A. As shown in FIG. 4A, in the conventional solar cell 1X, the finger parts 27f of the first electrode layer 27X are connected via the bus bar part 27b. As shown in FIG. 4B, in the solar cell 1X after the cutting, the finger parts 27f of the first electrode layer 27X are separated and there is no wiring member connected to the bus bar part 27b. This makes it difficult to extract carriers collected at the first electrode layer 27X, namely, extract output of the solar cell 1X.

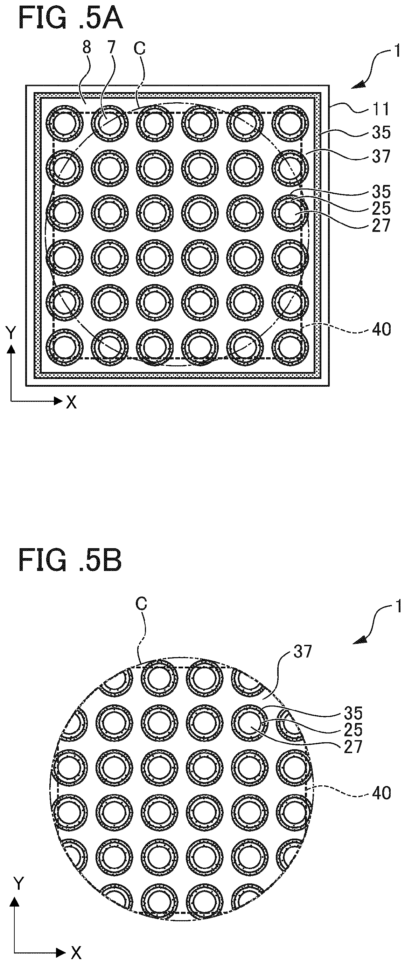

FIGS. 5A and 5B show how the solar cell 1 according to the present embodiment shown in FIG. 2 is cut into a circular shape. A solar cell having a circular shape shown in FIG. 5B is obtained by cutting the solar cell 1 along a circular cutting line C shown in FIG. 5A. As shown in FIG. 5A, in the solar cell 1 according to the present embodiment, a plurality of the first conductivity type semiconductor layers 25 and a plurality of the first electrode layers 27 are both arranged in island shapes, and a plurality of the first electrode layers 27 is connected via the plate-like electrode 40. Thus, as shown in FIG. 5B, a plurality of the first electrode layers 27 is still connected via the plate-like electrode 40 in the solar cell 1 after the cutting. This makes it possible to extract carriers via the plate-like electrode 40 after the carriers are collected at the first electrode layers 27, namely, extract output of the solar cell 1.

In the solar cell 1 according to the present embodiment, the second electrode layer 37 is formed into a sea shape. Thus, in the cut solar cell 1, separation of the second electrode layer 37 is prevented. This makes it possible to extract carriers collected at the second electrode layer 37, namely, extract output of the solar cell 1. Some of the island-shape first conductivity type semiconductor layers 25 and the sea-shape second conductivity type semiconductor layer 35 are exposed at an edge of a perimeter of the cut solar cell 1. Further, some of the island-shape first electrode layers 27 and the sea-shape second electrode layer 37 face the edge of the perimeter of the cut solar cell 1.

While a method of cutting the solar cell 1 into an arbitrary shape is not particularly limited, laser dicing or blade dicing may be employed, for example. Laser dicing is particularly preferable as it allows cutting out of a complicated shape or a curved plane. If a laser is used for cutting, a laser mark is formed on the edge of the perimeter (cutting plane) of the solar cell 1 after the cutting.

### <Extraction electrode>

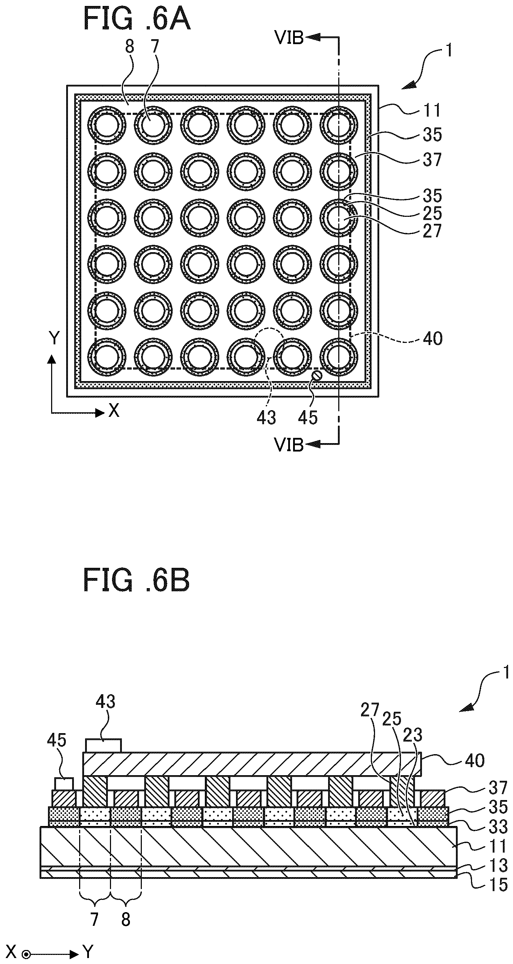

A method of forming an extraction electrode will be described next. The extraction electrode may be formed by a customer or by a manufacturer before shipment. FIG. 6A shows the solar cell (with extraction electrodes) according to the present embodiment as viewed from the back surface side. FIG. 6B is a cross-sectional view taken along a line VIB-VIB in the solar cell shown in FIG. 6A. As shown in FIGS. 6A and 6B, a first extraction electrode 43 is formed on the plate-like electrode 40, and a second extraction electrode 45 is formed on the second electrode layer 37. In FIG. 6A, the first extraction electrode 43 is indicated by dashed lines and the laminated structure of the solar cell 1 at the first extraction electrode 43 is shown in a perspective view. The first extraction electrode 43 and the second extraction electrode 45 are made of a metal material. Examples of the metal material include Cu, Ag, Al, and an alloy of these materials. For example, a printing method such as screen printing using Ag paste or a plating method such as electrolytic plating using Cu is employed as a method of forming the first extraction electrode 43 and the second extraction electrode 45. Alternatively, the first extraction electrode 43 and the second extraction electrode 45 may be formed by soldering, for example.

Generally, in a back electrode type solar cell used in a high-illuminance environment (for generation of high power), an electrode layer includes a metal electrode layer in addition to a transparent electrode layer in order to reduce electrical resistance loss occurring during electricity transport in a plane direction of the solar cell. By contrast, in a back electrode type solar cell mainly used in a low-illuminance environment (for generation of low power) for an electronic device such as a wearable device or a wristwatch, electrical resistance in a plane direction is not required to be reduced to a level comparable to a level required in the back electrode type solar cell used in a high-illuminance environment. For this reason, in the solar cell 1 according to the present embodiment, the sea-shape second electrode layer 37 is formed only of the transparent electrode layer while the metal electrode, namely, the extraction electrode 45 is formed into a small size on a part of the transparent electrode layer. If there arises a need to reduce the electrical resistance of the sea-shape second electrode layer 37 even in a low-illuminance environment, the second electrode layer 37 may include a metal electrode layer in addition to the transparent electrode layer.

In an ordinary solar cell panel, transporting electricity in a plane direction of a solar cell using a wiring member such as a tab wire or a smart wire is indispensable for suppressing electrical resistance loss. On the other hand, the back electrode type solar cell according to the present embodiment is preferably employed in an electronic device mainly used in a low-illuminance environment, particularly for wearable purposes (for wristwatch, smart watch, or sensor). In this case, the intensity of light generally emitted is low and electrical resistance loss is not serious compared to that in the solar cell panel. Thus, electricity in the plane direction within the plane of the solar cell is mainly transported using the plate-like electrode 40 and the second electrode layer 37, and this makes a difference from the ordinary solar cell panel. Transporting electricity in the plane direction mainly using the plate-like electrode 40 and the second electrode layer 37 prevents a wiring member from becoming a limitation in cutting out the solar cell into an arbitrary shape, and this further acts advantageously in using the solar cell according to the present embodiment for low-illuminance purposes. In the present embodiment, the plate-like electrode 40 is used for electrical transport through the island-shape first electrode layer 27, and the plate-like electrode is not used for electrical transport through the sea-shape second electrode layer 37. Specifically, in the present embodiment, the plate-like electrode only has one polarity.

### (Modification of extraction electrode)

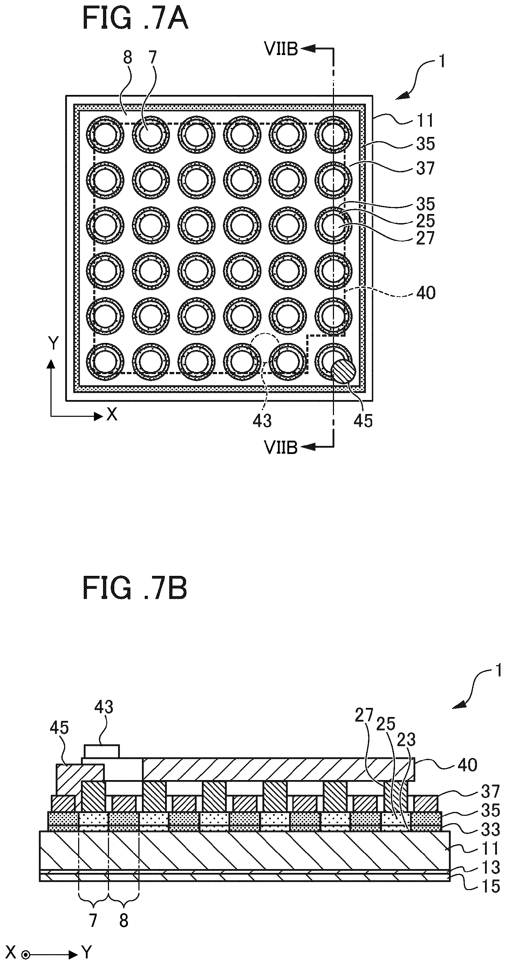

In consideration of cutting a solar cell into an arbitrary shape, the island-shape first electrode layer 27 desirably has a size of a certain degree of smallness for reducing loss. If the size of the island-shape first electrode layer 27 is small, the region of the sea-shape second electrode layer 37 not covered with the plate-like electrode 40 is reduced. Hence, in some cases, the second extraction electrode 45 is hard to form only on the sea-shape second electrode layer 37 in such a manner as to be absent from the first electrode layer 27 and the plate-like electrode 40. In this case, as shown in FIGS. 7A and 7B, the second extraction electrode 45 may be formed to extend from a part of the sea-shape second electrode layer 37 to a part of the island-shape first electrode layer 27. In this case, the plate-like electrode 40 is formed in such a manner as to avoid connection to the second extraction electrode 45 and the first electrode layer 27 on which the second extraction electrode 45 is formed.

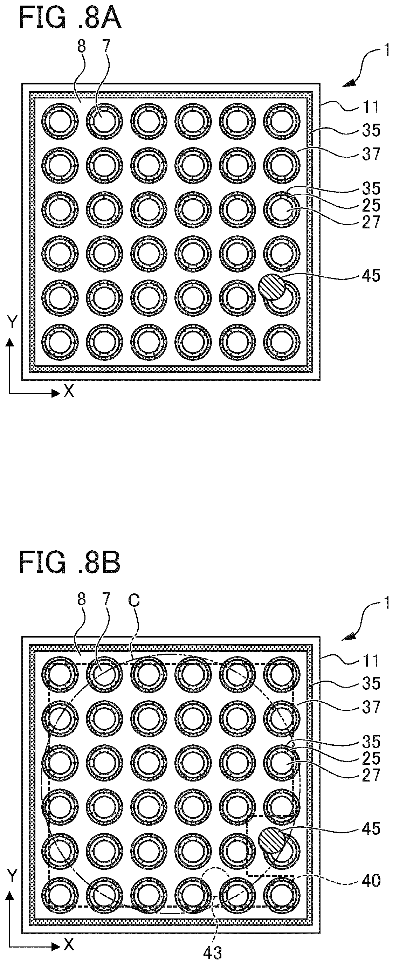

The second extraction electrode 45 may be formed before cutting or after the cutting. The second extraction electrode 45 may be formed before formation of the plate-like electrode 40 or after the formation of the plate-like electrode 40. Described next is an example of forming the second extraction electrode 45 before the cutting and before the formation of the plate-like electrode 40 by referring to FIGS. 8A to 8C. FIGS. 8A to 8C show an exemplary procedure of producing the solar cell according to the present embodiment. First, the solar cell 1 shown in FIG. 8A is prepared in which the passivation layer 13 and the anti-reflective layer 15 are formed on the light reception surface of the semiconductor substrate 11, the passivation layer 23, the first conductivity type semiconductor layer 25, and the first electrode layer 27 are formed in the island region 7 at the back surface of the semiconductor substrate 11, and the passivation layer 33, the second conductivity type semiconductor layer 35, and the second electrode layer 37 are formed in the sea region 8 at the back surface of the semiconductor substrate 11. The second extraction electrode 45 is formed at an intended position on the second electrode layer 37. In FIG. 8A, the second extraction electrode 45 is formed to extend from a part of the sea-shape second electrode layer 37 to a part of the island-shape first electrode layer 27.

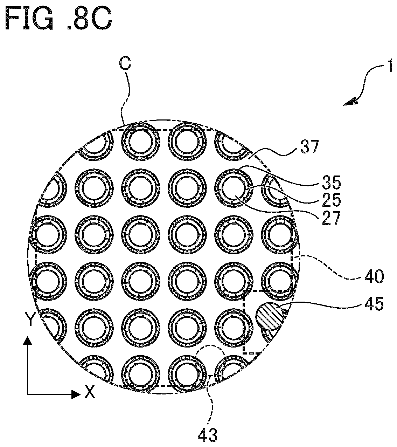

Next, as shown in FIG. 8B, the plate-like electrode 40 is formed on a plurality of the first electrode layers 27 in such a manner as to avoid contact with the second extraction electrode 45 and the first electrode layer 27 on which the second extraction electrode 45 is formed. Further, the first extraction electrode 43 is formed at an intended position on the plate-like electrode 40. Next, the solar cell 1 is cut along a cutting line C. In this way, the solar cell 1 after the cutting shown in FIG. 8C can be obtained. A manufacturer may provide a customer with the solar cell shown in FIG. 8A in a state before formation of the extraction electrodes in the solar cell. In this case, the customer is allowed to design the extraction electrodes or the solar cell freely and obtain the solar cell of an intended shape by following the foregoing procedure of producing the solar cell. In the example shown in FIG. 8B, one solar cell is cut out from one substrate. Alternatively, a plurality of solar cells may be cut out from one substrate.

### (First modification)

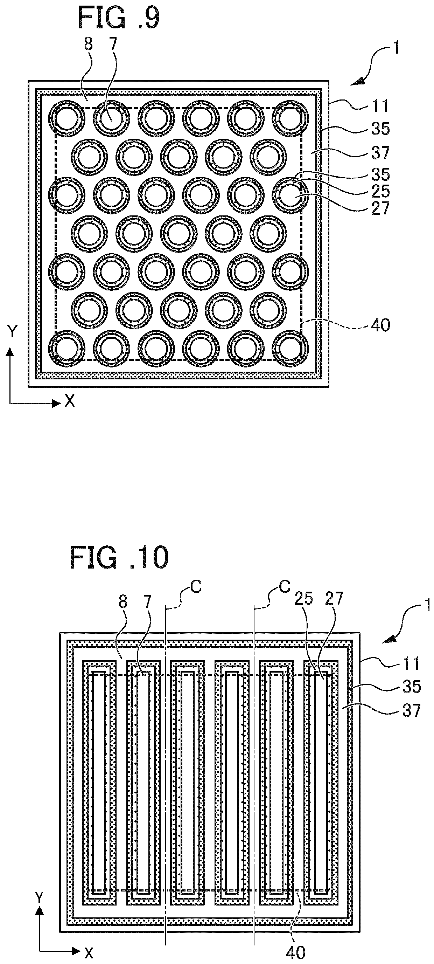

FIG. 9 shows a solar cell according to a first modification of the present embodiment as viewed from a back surface side. A solar cell 1 shown in FIG. 9 differs from that of the present embodiment in the arrangement of the island regions 7, namely, arrangement of the island-shape first conductivity type semiconductor layers 25 and first electrode layers 27 in the solar cell 1 shown in FIG. 2. As shown in FIG. 2, in the present embodiment, the island regions 7, namely, the island-shape first conductivity type semiconductor layers 25 and first electrode layers 27 are arranged on the points of intersection in the orthogonal grid. As shown in FIG. 9, in the first modification, the island regions 7, namely, the island-shape first conductivity type semiconductor layers 25 and first electrode layers 27 are arranged in a staggered pattern. More specifically, in the first modification, the island regions 7, namely, the island-shape first conductivity type semiconductor layers 25 and first electrode layers 27 adjacent to each other in the Y direction (first direction) are arranged in a staggered pattern in the X direction (second direction). This allows the island regions 7, namely, the island-shape first conductivity type semiconductor layers 25 and first electrode layers 27 to be arranged most closely (closest packed structure). In this case, all the first electrode layers 27 adjacent to each other can be arranged at an equal distance to achieve a uniform move distance of photocarriers.

### (Second modification)

FIG. 10 shows a solar cell according to a second modification of the present embodiment as viewed from a back surface side. A solar cell 1 shown in FIG. 10 differs from that of the present embodiment in the shape of the island regions 7, namely, the shapes of the island-shape first conductivity type semiconductor layers 25 and first electrode layers 27 in the solar cell 1 shown in FIG. 2. As shown in FIG. 10, the island regions 7, namely, the island-shape first conductivity type semiconductor layers 25 and first electrode layers 27 may be formed into strip-like shapes extending in the Y direction and may be arranged in the X direction. This facilitates cutting of the solar cell 1 into a strip shape along a cutting line C. In this way, the shape of the island regions 7, namely, the shapes of the island-shape first conductivity type semiconductor layers 25 and first electrode layers 27 may be changed appropriately in a manner that depends on a shape of cutting. In this case, as optionality of the cutting, the width of the strip can be set freely.

### (Third modification)

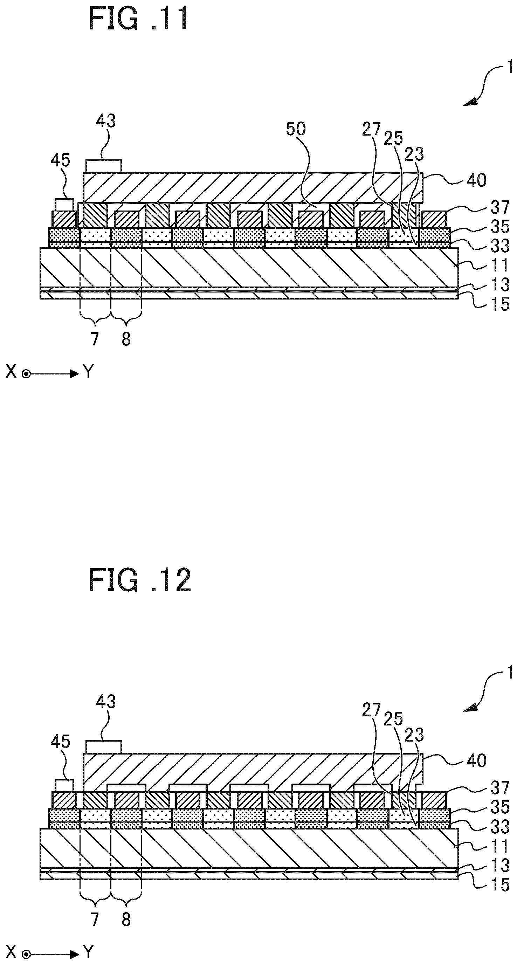

FIG. 11 is a cross-sectional view of a solar cell according to a third modification of the present embodiment. A solar cell 1 shown in FIG. 11 differs from that of the present embodiment in that an insulating layer 50 is further provided in the solar cell 1 shown in FIG. 3A. As shown in FIG. 11, the insulating layer 50 is provided in the sea region 8, namely, between the sea-shape second electrode layer 37 and the plate-like electrode 40. Various materials having insulating properties are applicable to a material of the insulating layer 50. For example, a photoresist, thermosetting resin, or ultraviolet curing resin is applicable. In terms of productivity, a particularly preferable method of forming the insulating layer 50 is to provide a pattern using a printing method in a region other than the first electrode layer 27. For example, a customer may be provided with a solar cell in which the insulating layer 50 is formed in a region other than the first electrode layer 27 in such a manner as to expose the island-shape first electrode layer 27 and cover the sea-shape second electrode layer 37. Regarding formation of a plate-like electrode on a customer side, the plate-like electrode 40 can be formed easily using a printing method or a plating method.

If the second extraction electrode 45 is to be formed on a customer side, the second electrode layer 37 located under the insulating layer 50 is required to be exposed partially and connected to the second extraction electrode 45. A method of connecting the second electrode layer 37 and the second extraction electrode 45 after formation of the insulating layer 50 is not particularly limited. If soldering is employed for forming the second extraction electrode 45, for example, the insulating layer 50 made of resin, for example, may be cut through by heat for establishing the connection. If a photoresist is used as the insulating layer 50, an opening may be formed in a part of the insulating layer 50 through exposure and development to expose the second electrode layer 37, and then the second electrode layer 37 and the second extraction electrode 45 may be connected.

### (Fourth modification)

FIG. 12 is a cross-sectional view of a solar cell according to a fourth modification of the present embodiment. A solar cell 1 shown in FIG. 12 differs from that of the present embodiment in the structures of the first electrode layer 27 and the plate-like electrode 40 in the solar cell 1 shown in FIG. 3A. As shown in FIG. 12, a major surface of the plate-like electrode 40 facing the semiconductor substrate 11 includes a protrusion contacting the island-shape first electrode layer 27, and a recess separated from the sea-shape second electrode layer 37. This plate-like electrode 40 can be realized using a metal sheet such as copper foil or a wiring sheet, for example. In this case, the height of the island-shape first electrode layer 27 is not required to be greater than that of the sea-shape second electrode layer 37 but may be substantially equal to or less than that of the second electrode layer 37.

### (Fifth modification)

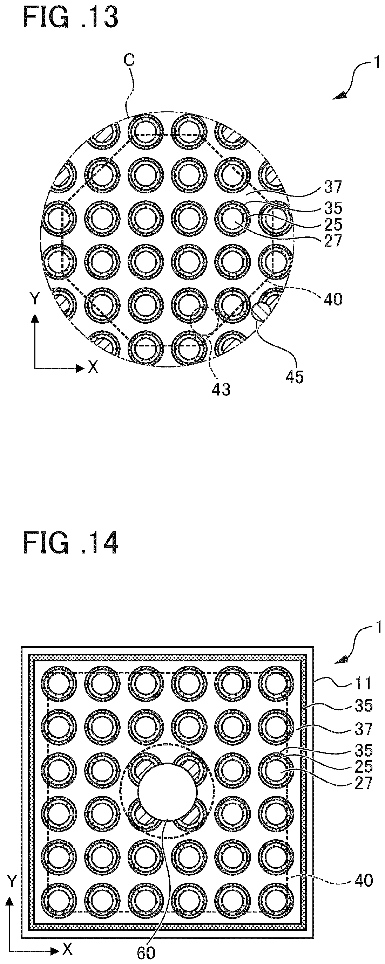

FIG. 13 shows a solar cell after cutting according to a fifth modification of the present embodiment as viewed from a back surface side. A solar cell 1 shown in FIG. 13 after cutting differs from that of the present embodiment mainly in the shape of the plate-like electrode 40 in the solar cell 1 after cutting shown in FIG. 5B. As described above, if the solar cell 1 is cut using laser dicing, for example, irradiating the first conductivity type semiconductor layer 25 or the second conductivity type semiconductor layer 35 with a laser beam causes damage on the first conductivity type semiconductor layer 25 or the second conductivity type semiconductor layer 35 to reduce output of the solar cell 1 slightly. As shown in FIG. 13, for example, if the solar cell 1 is cut into a circular shape, the first conductivity type semiconductor layer 25 or the second conductivity type semiconductor layer 35 is damaged at an edge of a perimeter (cutting plane) of the solar cell 1 after cutting. In the solar cell 1 according to the fifth modification, the edge of the perimeter of the solar cell 1 is irradiated with a laser beam to generate the first electrode layers 27 (points of diagonal lines) (namely, the first electrode layers 27 facing the edge of the perimeter of the solar cell 1) corresponding to at least one or more cut island-shape first conductivity type semiconductor layers 25. In this case, namely, if at least one or more first electrode layers 27 face an end face of the semiconductor substrate 11, it is preferable that the plate-like electrode 40 be formed in such a manner that at least some of these first electrode layers 27 are not connected to the plate-like electrode 40. Further, it is particularly preferable that the plate-like electrode 40 be formed so as not to be connected to all the first electrode layers 27 (namely, the first electrode layers 27 facing the edge of the perimeter of the solar cell 1) corresponding to the cut island-shape first conductivity type semiconductor layers 25. Specifically, the first electrode layer 27 connected to the plate-like electrode 40 is separated from the end face (cutting plane) of the solar cell 1. This suppresses reduction in output of the solar cell 1 to be caused by damage of a laser beam.

In particular, irradiating a pn junction with a laser beam causes serious output reduction of a solar cell. Hence, a semiconductor layer forming the pn junction is preferably the island-shape first conductivity type semiconductor layer 25 and not connected to the plate-like electrode 40. Namely, unlike the island-shape first conductivity type semiconductor layer 25, the semiconductor substrate 11 preferably has the second conductivity type same as that of the sea-shape second conductivity type semiconductor layer 35. Irradiating the second conductivity type semiconductor layer 35 not forming a pn junction with a laser beam causes output reduction of a solar cell but this reduction is slight.

In particular, minimizing the size of the island region 7, namely, minimizing the sizes of the island-shape first conductivity type semiconductor layer 25 and first electrode layer 27 reduces the area of the island-shape first conductivity type semiconductor layer 25 to be cut. Thus, output reduction of the solar cell can be suppressed to a greater extent. As a method of separating the plate-like electrode 40 and the cut island-shape first conductivity type semiconductor layer 25, after the solar cell is cut on a customer side or a manufacturer side, the plate-like electrode 40 may be formed in such a manner as to be absent from the first electrode layer 27 (namely, the first electrode layer 27 facing the edge of the perimeter of the solar cell) corresponding to the cut island-shape first conductivity type semiconductor layer 25. Alternatively, before the solar cell is cut on the customer side or the manufacturer side, the plate-like electrode 40 may be formed in such a manner as to be absent from the first electrode layer 27 (namely, the first electrode layer 27 facing the edge of the perimeter of the solar cell) corresponding to the island-shape first conductivity type semiconductor layer 25 to be cut in a cutting step.

### (Sixth modification)

FIG. 14 shows a solar cell according to a sixth modification of the present embodiment as viewed from a back surface side. A solar cell 1 shown in FIG. 14 differs from that of the present embodiment mainly in that a through hole is formed in the solar cell 1 shown in FIG. 2. As shown in FIG. 14, the solar cell 1 may have a through hole 60 formed at an arbitrary position. The through hole 60 may be formed by a method such as laser dicing described above. The through hole 60 is provided as a viewing window at a display part provided at a lower position of the solar cell 1 or as a hole for a hand axis of a wristwatch, for example, in an electronic device such as a wearable device or a wristwatch. In this case, as described above, the plate-like electrode 40 may be formed so as not to be connected to at least some, or more preferably, all of the first electrode layers 27 (points of diagonal lines) (namely, the first electrode layers 27 facing an edge of the solar cell 1 at the through hole 60) corresponding to the island-shape first conductivity type semiconductor layers 25 cut as a result of irradiation of the edge of the solar cell 1 at the through hole 60 (indicated by diagonal lines). Specifically, the first electrode layer 27 connected to the plate-like electrode 40 is separated from the end face (cutting plane) of the solar cell 1 at the through hole 60. This suppresses reduction in output of the solar cell 1 to be caused by damage of a laser beam.

### (Electronic device)

For actual use of the solar cell 1 according to the present embodiment, the solar cell 1 is preferably configured as a module. The solar cell is configured as a module by an appropriate method. For example, a wire or a contact pin may be connected to the extraction electrodes 43 and 45 functioning as an anode and a cathode to allow extraction of electricity. A back electrode type solar cell is configured as a module by being sealed with a sealing agent and a glass plate. The solar cell configured as a module in this way becomes installable on an electronic device for wearable purposes (for wristwatch, smart watch, or sensor).

While the embodiments according to the present invention have been described so far, the present invention is not limited to the above-described embodiments, and various modifications are available. In the present embodiment, the heterojunction type solar cell has been described. In an example, the feature of the present invention may be applied to various types of solar cells such as a homojunction type solar cell, not limited to such a heterojunction type solar cell.

The back electrode type solar cell 1 shown as an example in the present embodiment described above includes the passivation layer 23, the first conductivity type semiconductor layer 25, and the first electrode layer 27 sequentially laminated in the island region (first conductivity type region) 7 at the back surface of the semiconductor substrate 11, and the passivation layer 33, the second conductivity type semiconductor layer 35, and the second electrode layer 37 sequentially laminated in the sea region (second conductivity type region) 8 at the back surface of the semiconductor substrate 11 except the island region 7. However, the feature of the present invention is not limited to this solar cell 1 but is further applicable to a back electrode type solar cell in which at least a part of a first conductivity type semiconductor layer and at least a part of a second conductivity type semiconductor layer overlap each other. This solar cell may be realized by forming a first electrode layer corresponding to the first conductivity type semiconductor layer into an island shape like the foregoing first electrode layer 27, forming a second electrode layer corresponding to the second conductivity type semiconductor layer into a sea shape like the foregoing second electrode layer 37, and forming a sea-island structure using the first electrode layer and the second electrode layer.

### EXPLANATION OF REFERENCE NUMERALS

1, 1X Solar cell
7 First conductivity type region (island region)
8 Second conductivity type region (sea region)
11 Semiconductor substrate
13, 23, 33 Passivation layer
15 Anti-reflective layer
25, 25X First conductivity type semiconductor layer
27, 27X First electrode layer
27b, 37b Bus bar part
27f, 37f Finger part
35, 35X Second conductivity type semiconductor layer
37, 37X Second electrode layer
40 Plate-like electrode
43 First extraction electrode
45 Second extraction electrode
50 Insulating layer
60 Through hole

## Claims

1. A back electrode type solar cell comprising a semiconductor substrate, a first conductivity type semiconductor layer and a second conductivity type semiconductor layer arranged on a back surface of the semiconductor substrate, a first electrode layer corresponding to the first conductivity type semiconductor layer, and a second electrode layer corresponding to the second conductivity type semiconductor layer, wherein
the second electrode layer and a plurality of the first electrode layers form a sea-island structure in which the first electrode layers have island shapes and the second electrode layer has a sea shape, and
the solar cell comprising a plate-like electrode arranged to face the back surface of the semiconductor substrate, connected to a plurality of the first electrode layers, and not connected to the second electrode layer.

2. The solar cell according to claim 1, wherein the height of the first electrode layer is greater than that of the second electrode layer.

3. The solar cell according to claim 1, wherein a surface of the plate-like electrode facing the semiconductor substrate includes a protrusion contacting the first electrode layer and a recess separated from the second electrode layer.

4. The solar cell according to any one of claims 1 to 3, further comprising an extraction electrode formed on the second electrode layer and used for extracting a current from the second electrode layer, wherein
the extraction electrode contains a metal material and is formed on a part of the second electrode layer.

5. The solar cell according to claim 4, wherein the extraction electrode is formed to extend from a part of the second electrode layer to a part of at least one first electrode layer not connected to the plate-like electrode of a plurality of the first electrode layers.

6. The solar cell according to any one of claims 1 to 5, wherein a plurality of the first electrode layers is arranged two-dimensionally at the back surface of the semiconductor substrate, and
adjacent ones of the first electrode layers adjacent to each other in a first direction along the back surface of the semiconductor substrate are arranged in a staggered pattern in a second direction orthogonal to the first direction.

7. The solar cell according to any one of claims 1 to 6, wherein the semiconductor substrate is a second conductivity type semiconductor substrate.

8. The solar cell according to claim 7, wherein the width of the second electrode layer caught between adjacent ones of the island-shape first electrode layers, or between the island-shape first electrode layer and a perimeter of the semiconductor substrate, is equal to or less than 6 mm.

9. The solar cell according to any one of claims 1 to 6, wherein the semiconductor substrate is a first conductivity type semiconductor substrate, and
the width of the first electrode layer is equal to or less than 6 mm.

10. The solar cell according to any one of claims 1 to 9, further comprising an insulating layer arranged between the plate-like electrode and the second electrode layer.

11. The solar cell according to any one of claims 1 to 10, wherein some of a plurality of the first electrode layers and the second electrode layer face an end face of the semiconductor substrate.

12. The solar cell according to any one of claims 1 to 11, wherein a laser mark is formed on an end face of the semiconductor substrate.

13. The solar cell according to any one of claims 1 to 12, wherein the semiconductor substrate has a through hole.

14. The solar cell according to any one of claims 11 to 13, wherein at least some of the first electrode layers facing the end face of the semiconductor substrate are separated from the plate-like electrode.

15. The solar cell according to claim 14, wherein all the first electrode layers connected to the plate-like electrode are separated from the end face of the semiconductor substrate.

16. The solar cell according to any one of claims 1 to 15, wherein the plate-like electrode has a mesh-like shape.

17. The solar cell according to any one of claims 1 to 16, wherein the plate-like electrode contains Ag particles.

18. The solar cell according to any one of claims 1 to 17, wherein the plate-like electrode is a metal sheet.

19. A back electrode type solar cell comprising a semiconductor substrate, a first conductivity type semiconductor layer and a second conductivity type semiconductor layer arranged on a back surface of the semiconductor substrate, a first electrode layer corresponding to the first conductivity type semiconductor layer, and a second electrode layer corresponding to the second conductivity type semiconductor layer, wherein
the second electrode layer and a plurality of the first electrode layers form a sea-island structure in which the first electrode layers have island shapes and the second electrode layer has a sea shape,
the solar cell comprising an insulating layer covering the second electrode layer while a plurality of the first electrode layers is exposed from the insulating layer.

20. The solar cell according to claim 19, further comprising a plate-like electrode arranged to face the back surface of the semiconductor substrate, connected to a plurality of the first electrode layers, and not connected to the second electrode layer.

21. An electronic device comprising the solar cell according to any one of claims 1 to 20.
